# EUROPEAN PATENT SPECIFICATION

(11) **EP 3 782 202 B1**
(45) Date of publication and mention of the grant of the patent: **15.10.2025**
(21) Application number: 19719197.6
(22) Date of filing: 12.04.2019
(51) Int. Cl.: H10F 19/80, H10F 77/00, H10F 77/42

(54) **PHOTOVOLTAIC MODULES AND METHODS OF MANUFACTURE THEREOF**
FOTOVOLTAIKMODULE UND HERSTELLUNGSVERFAHREN DAFÜR
MODULES PHOTOVOLTAÏQUES ET LEURS PROCÉDÉS DE FABRICATION

(30) Priority: 16.04.2018 WO PCT/EP2018/059636
(43) Date of publication of application: 24.02.2021
(73) Proprietor: CSEM Centre Suisse d'Electronique et de Microtechnique SA - Recherche et Développement, 2002 Neuchâtel (CH)
(72) Inventor: SÖDERSTRÖM, Karin, 2000 Neuchâtel (CH); BULLIARD, Xavier, 1690 Lussy (CH); FUERHOLZ, Urs, 1723 Marly (CH); CATTANEO, Gianluca, 2000 Neuchâtel (CH); GALLIANO, Federico, 1005 Lausanne (CH); PERRET-AEBI, Laure-Emmanuelle, 2000 Neuchâtel (CH)
(74) Representative: e-Patent SA
(86) International application number: PCT/EP2019/059426
(87) International publication number: WO 2019/201775

(56) References cited:
- EP-A1- 2 623 314
- EP-A2- 0 766 320
- EP-A2- 1 458 035
- EP-B1- 3 703 945
- WO-A1-2016/146676
- US-A- 5 474 620
- US-A1- 2011 308 578
- US-A1- 2012 282 437

## Description

### Technical Field

The present invention relates to the technical field of photovoltaic devices. More particularly, it relates to photovoltaic devices comprising a fibre mesh, as well as to methods of manufacture thereof.

### State of the art

The natural colour of photovoltaic (PV) devices, also referred to as solar cells or solar panels, tends to be near black, often with a purple or indigo tint, with a clearly-defined pattern of the individual cells being visible. When such PV devices are mounted on buildings they can be unsightly, and it is often unacceptable to use them directly as building cladding for this reason.

In order to overcome this problem, coloured PV devices have been proposed, which enable their integration into the structure of a building, notably as exterior cladding.

Document US 9,281,186 discloses a film placed on the front sheet of the PV device to modify the appearance of the module. However, this film requires a specific profile which requires alignment with the geometry of the individual PV cells making up the module, and relies on a complex design involving facets in the front sheet and embedded elements in the inactive part of the module.

US 2014/326292 discloses a PV device comprising a graphic film placed inside the module. This film is printed with a colour or texture, and requires a selective reflector layer to limit the impact of the film on the efficiency of the module.

US 9,276,141 and US 8,513,517 disclose decorative film overlays placed on or within a PV module.

However, all of these prior art solutions are either complex, or require extra continuous layers to be applied to modules. Essentially, for each additional layer added to a module, the risk of delamination of the module increases since there are more interfaces between layers which can separate. Furthermore, special manufacturing techniques or equipment may be required.

Document EP1458035 discloses an alternative, in which nonwoven glass fibre mesh layers are embedded in the front encapsulant material, in contact with the front sheet and the PV conversion device. During lamination, the encapsulant material, which is placed in the laminator between the mesh layers, flows around the mesh fibres and seals to the adjacent layers. However, since the mesh is in contact with the adjacent layers, there is a high risk of "dry spots", i.e. areas in which the encapsulant does not flow entirely around the fibres, leaving unencapsulated portions of these in contact with the adjacent layer. This significantly reduces the structural stability of the laminated module, since it reduces the area of contact between the encapsulant and the front sheet and/or PV conversion device. Furthermore, the mesh is not intended to have any visible optical effect, and requires an additional surface treatment with silane.

EP2623314 describes a similar arrangement, in which the front encapsulant is reinforced with transparent fibres, preferably glass fibres, in either woven or non-woven sheets or mats. This is done in order to improve the mechanical strength of the module, but is not intended to provide a visible effect despite the relatively high fibre reinforcement of 20-80 vol%. This translates into a range of approximately 100 g/m² to 400g/m² for 0.2mm fibres.

EP0766320 describes a PV module in which fibres are used as a mould to emboss the surface of the encapsulant with a pattern during lamination, however no fibres are incorporated into the structure of the module.

US2011/308578 discloses a PV module in which a coloured fibre mesh is situated in the back side encapsulant of the module.

US 5,474,620 discloses another PV module with an uncoloured fibreglass mesh provided in the front encapsulant.

The aim of the present invention is thus to at least partially overcome the above-mentioned drawbacks of the prior art.

### Disclosure of the invention

More specifically, the invention relates to a photovoltaic module as defined in claim 1, the module comprising:
- a front sheet arranged on a light incident side of said photovoltaic module, made of e.g. glass, transparent ceramic, polymer or other suitable transparent material;
- a back sheet arranged on an opposite side of said photovoltaic module to the front sheet, the back sheet being made of e.g. glass, metal, polymer, ceramic or other material;
- a photovoltaic conversion device disposed between said front sheet and said back sheet, the PV conversion device being of any convenient type;
- a front encapsulation layer disposed between said photovoltaic conversion device and said front sheet, this layer comprising a thermoplastic or crosslinkable polymer such as EVA, polyolefin or similar. A back encapsulant between the PV conversion device and the back sheet can also be provided, if required.

The front encapsulation layer comprises a fibre mesh embedded therein, at any desired distance between the adjacent layers, and according to the invention, the fibre mesh comprises coloured fibres (the fibres e.g. being coloured on their surface and/or in their structure with a colourant and/or pigment), and/or a colour, image or pattern printed thereupon, at least a portion of said front encapsulation layer being situated between said fibre mesh and said photovoltaic conversion device, this portion being white or coloured.

By providing a coloured or printed fibre mesh as mentioned above, the visual appearance of the module can be made suitable for integration in buildings, and so on, without requiring special manufacturing processes or expensive layers, in a manner which is compatible with conventional processing techniques, particularly lamination. The white or other coloration of the said portion of the front encapsulation layer provides a good background colour for an image or other printing provided on the mesh, further improving the appearance of the module.

Advantageously, said fibre mesh is embedded in the front encapsulation layer such that said fibre mesh is out of contact with each non-encapsulant layer adjacent to said front encapsulation layer. In other words, there is a zone of encapsulant material which does not contain fibres adjacent to the next layer, whether that be the PV conversion device, the front sheet, or any other non-encapsulant layer. The fibre mesh may be coloured or printed as described above.

As a result, the adhesion of the encapsulant to the adjacent layers cannot be compromised by the presence of fibres, and the fibre mesh can be completely penetrated from both sides by encapsulant. As a result, the structural integrity of the module is improved over those of the prior art, in which fibre meshes are present in contact with the front sheet and/or the PV device.

Advantageously, said fibre mesh comprises individual fibres with a diameter between 5 µm or 10 µm and 1 mm, preferably between 5 µm and 20 µm, said individual fibres being arranged in a regular or irregular pattern, and being woven or unwoven. The fibre mesh may for instance have a density of between 5 g/m2 and 250 g/m2, preferably between 10 g/m2 and 150 g/m2, further preferably between 5 g/m² and 80 g/m², further preferably between 35 g/m² and 50 g/m².

These ranges provide a good visual effect and do not typically cause a significant reduction in the external quantum efficiency or the current produced by the underlying photovoltaic device, notably in the case in which the mesh is made of glass fibre or other colourless fibres.

The fibre mesh of the invention comprises a colour, image or pattern printed thereupon. Alternatively, the fibre mesh itself may create a visible pattern or texture. This enables further modification of the visual appearance of the PV module.

Advantageously, the module can further comprise an internal front sheet situated adjacent to said front encapsulation layer, and an internal front encapsulation layer situated between said internal front sheet and said photovoltaic conversion device. Such a construction can be easily fabricated by applying the front sheet and front encapsulant to a pre-existing, pre-fabricated PV device, and thereby provide the advantages of the invention to pre-existing, commercially-available PV modules.

Advantageously, the encapsulant material of the front encapsulant is based on TPO (thermoplastic polyolefins), and the front sheet is based on ETFE (ethylene tetrafluoroethylene). This gives a surprising technical effect in improving the chemical stability of the coloration or printing on the fibre mesh under prolonged exposure to sunlight.

The invention furthermore relates to a method of manufacturing a photovoltaic module as defined in claim 7, the method comprising the steps of:
- providing a lamination device such as a vacuum bag or other lamination device;
- disposing in the lamination device a layer stack comprising:
- a front sheet intended to be arranged on a light incident side of said photovoltaic module, the front sheet being made of e.g. glass, transparent ceramic, polymer, or other suitable transparent material;
- a back sheet intended to be arranged on an opposite side of said photovoltaic module to the front sheet, the back sheet being made of e.g. glass, metal, polymer, ceramic or other material;
- a photovoltaic conversion device of any convenient type disposed between said front sheet and said back sheet;
- at least one front encapsulation layer disposed between said photovoltaic conversion device and said front sheet. A back encapsulant between the PV conversion device and the back sheet can also be provided, if required;
- a coloured and/or printed fibre mesh immediately adjacent to said at least one front encapsulation layer; if two or more layers of front encapsulant are provided, the mesh may be situated between them;
- applying heat and pressure to said layer stack so as to assemble it into said photovoltaic module by means of fusing and/or cross-linking the encapsulant layer(s).

At least one said front encapsulation layer is situated between said fibre mesh and said photovoltaic conversion device and is white or coloured.

The layer stack can be assembled with either the front sheet or back sheet downwards.

As a result, the front encapsulant layer will fuse and flow into the coloured or printed mesh, resulting in a PV device incorporating a fibre mesh in its front encapsulant. This renders the visual appearance of the module suitable for integration in buildings and so on, without requiring special manufacturing processes or expensive layers since it uses conventional lamination techniques. Furthermore, the colouration (white or coloured) of the resulting at least a portion of said front encapsulation layer which is situated between said fibre mesh and said photovoltaic conversion device provides a good background colour for an image or other printing provided on the mesh, further improving the appearance of the module.

Advantageously, the fibre mesh can be disposed between two layers of front encapsulation material, such that the mesh ends up part way through the thickness of the front encapsulant, which flows into it from each side. The possibility of dry spots of mesh which have not been wetted by fused encapsulant material is hence reduced, which maximises the strength of the arrangement.

Advantageously, said fibre mesh may comprise individual fibres with a diameter between 5 µm or 10 µm and 1 mm, said individual fibres being arranged in a regular or irregular pattern, and being woven or unwoven. The fibre mesh may also have a density of between 5 g/m² and 250 g/m², preferably between 10 g/m² and 150 g/m², further preferably between 35 g/m² and 50 g/m².

These ranges provide a good visual effect, and do not typically cause a significant reduction in the external quantum efficiency or the current produced by the underlying photovoltaic device, notably in the case in which the mesh is made of glass fibre or other colourless fibres.

### Brief description of the drawings

Further details of the invention will appear more clearly upon reading the description below, in connection with the following figures which illustrate:
- Figure 1: a schematic cross-sectional view of a photovoltaic module according to the invention;
- Figures 2a and 2b: schematic representations of various meshes which can be used with the PV module according to the invention;
- Figures 3a and 3b: schematic cross-sectional views of variations on the photovoltaic module of figure 1;
- Figure 4: a schematic cross-sectional view of a further photovoltaic module according to the invention;
- Figures 5 and 6: charts of experimental results obtained with PV modules according to the invention;
- Figure 7: a schematic view of light scattering in a photovoltaic module according to figure 1;
- Figure 8: a further chart of experimental results obtained with various PV modules according to the invention;
- Figure 9: schematic representation of the manufacture of a photovoltaic module according to the invention by means of a lamination device; and
- Figure 10: a schematic representation of a building structure provided with a photovoltaic module according to the invention.

### Embodiments of the invention

It should be noted in the following that, unless explicitly stated that a particular layer is disposed directly on the adjacent layer, it is possible that one or more intermediate layers can also be present between the layers mentioned. As a result, "on" should be construed by default as meaning "directly or indirectly on". Furthermore, patterning of certain layers, connectors and so on are not represented since they are well-known to the skilled person.

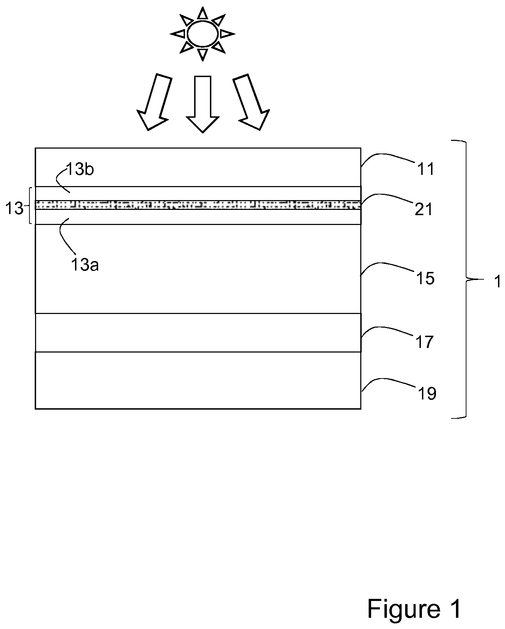

Figure 1 illustrates a first embodiment of a photovoltaic (PV) module 1 according to the invention.

This module 1 comprises a front sheet 11, on the light incident side of the module 1, intended to be illuminated in use (as indicated in the figures by means of a sun symbol), and a back sheet 19, on the opposite side of the module 1 to the front sheet 11. The front sheet may be glass, transparent ceramic, polymer or any other convenient substantially transparent material, and the back sheet may be metal, glass, ceramic, polymer or any other convenient material. The front sheet 11 may be structured, and may be provided with coatings.

Situated between the front and back sheets is a photovoltaic conversion device 15 comprising one or more PV cells comprising NIP, PIN, NP or PN semiconductor junctions, patterned and interconnected as is generally known. The PV cells may be based on thin-film silicon, crystalline silicon, germanium, perovskite, dye-sensitised cells, or any other type of PV technology adapted to generate electrical power from light impinging on the light-incident side of the PV module 1.

The PV conversion device 15 is encapsulated on its front side by a front encapsulant 13, which seals it to the front sheet 11, and on its back side by a rear encapsulant 17. This latter seals the PV conversion device 15 to the back sheet 19, although it may indeed itself form the rear sheet. The encapsulants can be standard substances such as polyolefin, EVA (ethylenevinyl acetate), polyvinyl butyral, thermoplastic polyurethane elastomer, ionomer, silicone or similar.

It should be noted that other intermediate layers may be provided between the illustrated layers, and that the layers do not have to be flat and can describe curves or more complex surfaces.

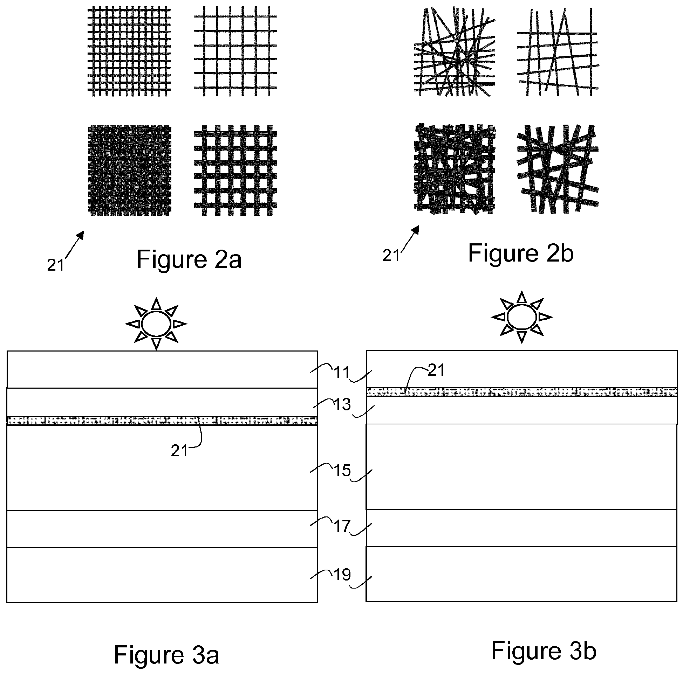

According to the invention, a fibre mesh 21 is incorporated into the front encapsulant 13. This mesh 21 is typically provided as a mat of fibres aligned in different directions, interweaved or simply laid upon each other (i.e. either woven or non-woven), in a regular or irregular pattern. Figure 2a illustrates in schematic plan view variations of regular fibre meshes 21 at varying densities, and figure 2b illustrates quasi-random fibre meshes in which the angles and positions of the individual fibres are irregular.

The fibres can be made of metal, polymer, glass or similar, and can have diameters from 5 µm to 1mm or from 10µm to 1mm. Fibres from about 10µm to 100µm are typically invisible to the naked eye, whereas those from about 100µm to 1mm are visible, and give the PV device 1 a visible texture or pattern. The fibres may be continuous lengths from one side of the module 1 to the other, or may be shorter, particularly in the case of an irregular arrangement of fibres, and the thickness of the fibre mat may vary from twice the fibre diameter to 3mm.

The fibres are coloured, dyed or printed upon, for instance by inkjet printing, sublimation, lithography, screen printing, dipping, bar coating, slot-die coating or similar to create block colours, patterns or to provide images thereupon that will be visible. This printing can be carried out before placing the mesh 21 in a lamination device, or can even be carried out in-situ, when the mesh has been positioned in a lamination device but before lamination has been carried out.

In the case of printed fibres, the portion 13a of the front encapsulant 13 below the mesh 21, i.e. on the side facing away from the light-incident side of the PV device 1, is white or coloured so as to provide a good background for visibility of the printing provided on the fibres.

Typically, the front encapsulant 13 has a thickness of between 100 µm and 3mm or more, typically between 100 µm and 2000 µm. In the embodiment of figure 1, the PV module 1 is produced in the conventional manner, by stacking the various layers in a lamination device in the correct order, and subsequently applying heat and pressure so as to fuse and/or cross-link the encapsulant and bind the various layers together.

In order to integrate the fibre mesh 21 into the front encapsulant, several variations are possible.

In the embodiment of figure 1, the fibre mesh 21 is laid into the layer stack between two sheets of encapsulant material 13a, 13b, with the layer stack oriented either with the front sheet 11 or the back sheet 19 down in a lamination device (not illustrated in figure 1). Heat and pressure sufficient to cause the encapsulant to soften and flow are then applied as normal, and the two sheets of encapsulant material 13a, 13b fuse together and flow around the fibres of the fibre mesh 21, thereby integrating the mesh 21 with the resulting front encapsulant layer 13. As normal, this process causes the front and rear encapsulants 13, 17 to adhere to their respective adjacent layers, as normal. This process is compatible with all types of lamination, including hot-press and vacuum lamination, as well as roll-to-roll processes for flexible photovoltaic devices.

In figure 1, the two sheets of encapsulant material 13a, 13b are of the same thickness, however they can have different thicknesses so as to position the mesh 21 at any location desired in the thickness of the front encapsulant 13. The lower sheet 13a is white or coloured in order to provide an appropriate background colour to the fibres and to any printing thereupon.

This particular construction ensures that the mesh 21 is kept out of contact with any layer which is adjacent to the front encapsulant layer 13 (in this case the front sheet 11 and the PV conversion device. This ensures that there are no zones of the adjacent layers which are not in contact with encapsulant material, thus ensuring excellent mechanical strength despite the presence of the mesh 21. Furthermore, the encapsulant easily penetrates from both sides of the mesh towards its centre, ensuring that voids are avoided.

Figure 3a illustrates a variant not forming part of the invention in which the fibre mesh 21 is disposed immediately adjacent to the PV device, and is coloured or printed upon, as mentioned above. To manufacture this arrangement, it is possible to use a single layer of front encapsulant 13, however better adhesion to the PV conversion device 15 is achieved by using a very thin film of encapsulant (e.g. with a thickness up to half the thickness of the fibre mesh 21) which almost entirely flows into the fibre mesh 21 to ensure that there are no points of contact between mesh 21 and PV conversion device 15 which are not covered by encapsulant material.

Figure 3b illustrates a further embodiment in which the coloured or printed fibre mesh 21 is disposed immediately adjacent to the front sheet 11. The same comments as in respect of figure 3a apply equally here, mutatis mutandis, regarding use of a single layer of encapsulant or one thick and one thin layer thereof.

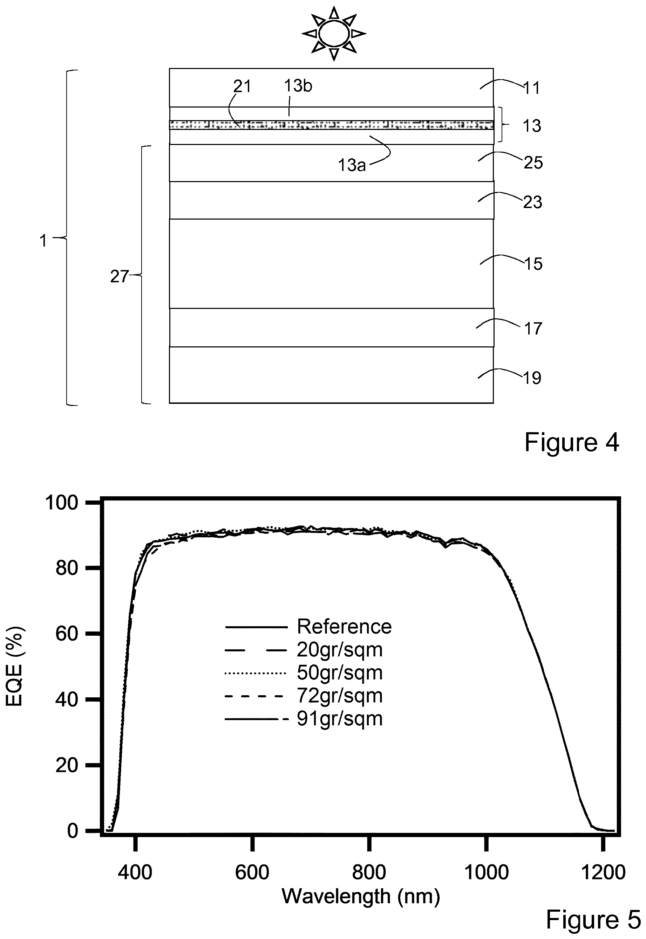

Figure 4 illustrates a yet further construction of a PV module 1 according to the invention. In this construction, the front encapsulant layer 13 and the front sheet 11 are laminated in a lamination device under conditions of heat and pressure onto a pre-existing prefabricated PV module 27, which hence already comprises its own front sheet which becomes inner front sheet 25 and its own front encapsulation which becomes internal front encapsulation 23. The remaining layers 15, 17 and 19 are as before and need not be described again. The variations to front encapsulant layer 13 as described in relation to figure 3b are equally applicable in this embodiment.

This arrangement allows the visual advantages of the invention to be applied to any commercially-available PV module 27, by laminating the front encapsulant 13 and front sheet 11 layers onto the existing module 27.

In order to assess whether the presence of the fibre mesh 21 negatively influences the structural integrity of a module 1 according to the variant of figure 1, a conventional 90° peeling test was carried out using random glass fibre as mesh 21 and EVA as encapsulant, so as to measure the adhesion between the mesh and the encapsulant. As a reference, the same peeling test was carried out between the same encapsulant material and a glass plate. The results obtained are as follows:

**(Table 1)**

| | Ref | 10 g/m² mesh | 21 g/m² mesh | 50 g/m² mesh | 72 g/m² mesh | PET film |
|---|---|---|---|---|---|---|
| Adhesion (N/cm) | >200 | >200 | >200 | >200 | 145 | <15 |

As can clearly be seen, for a mesh density of 50 g/m² or less, the adhesion remains above 200 N/cm, above which the adhesion reduces due to incomplete impregnation of the denser mesh by the encapsulant material at higher mesh densities. However, in any case the adhesion at 72 g/m² density is still high, and is significantly above that of a continuous PET film construction.

Next, the performance losses due to the fibre mesh 21 were measured, again using random, uncoloured glass fibre as before for the fibre mesh 21, again with a module 1 according to figure 1.

Samples of PV modules according to the invention were fabricated, and the external quantum efficiency (EQE) of the resulting PV module was measured. The results are reproduced in figure 5, for mesh densities of 20 g/m², 50 g/m², 72 g/m² and 91 g/m². As can clearly be seen, the effect of the presence of the mesh is rather minimal, with losses of no more than 1% compared to a reference with the same thickness of front encapsulant but with no fibre content.

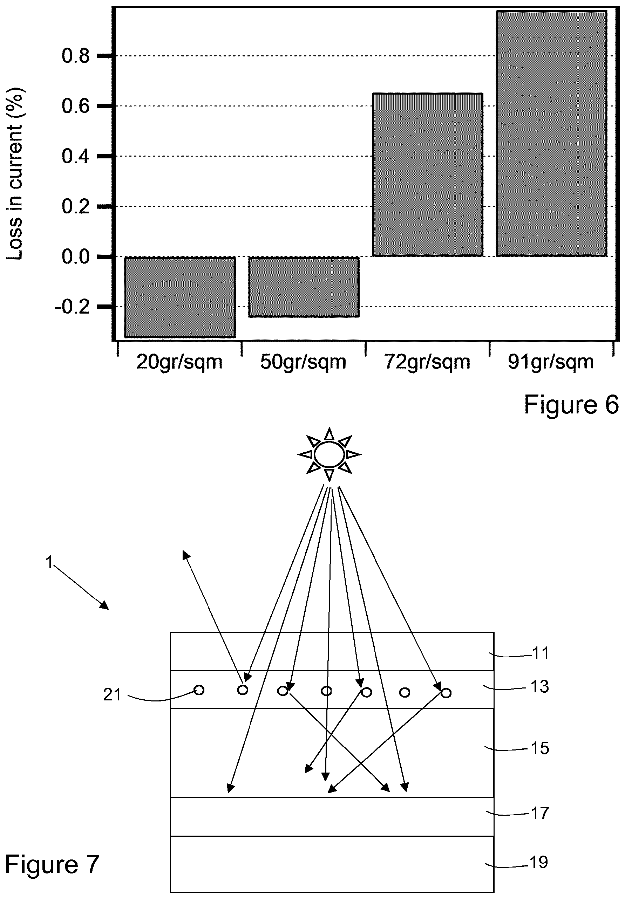

Figure 6 illustrates a graph of the current loss for the same series of tests. The loss in all of the tests is limited to 1% at most, and it is noted that the apparent gain of current for 20 g/m² and 50 g/m² is within the measurement error, but could indeed represent a genuine - albeit trivial - gain due to improved scattering of light due to the fibre mesh.

Indeed, the relatively trivial reduction of EQE and current due to the presence of the fibre mesh is an unexpected and surprising effect. At the fibre densities tested, only a relatively very small amount of light impinging on the fibres is reflected or scattered back towards the light-source side. The majority of the incident light either passes between the fibres, or is refracted, reflected or scattered therefrom at an angle that nevertheless causes it to pass through the photovoltaically active layers 15, as indicated by figure 7. Furthermore, since the fibres in this example are colourless, a certain amount of light will pass straight through them. In this figure, the fibre mesh 21 has been represented schematically by a number of circles representing the cross-section of a number of fibres, and certain light pathways have been illustrated to indicate various ways in which light can either be reflected from, or can enter the PV module 1.

It appears from the results that, at least up to around 50g/m² fibre density for the colourless glass fibres tested, that the scattering of a certain amount of light, which leads to longer light pathways through the photovoltaically-active layers of the PV device 15, compensates at least partially for the losses associated with scattering and reflection of light back towards the light-incident side of the module 1.

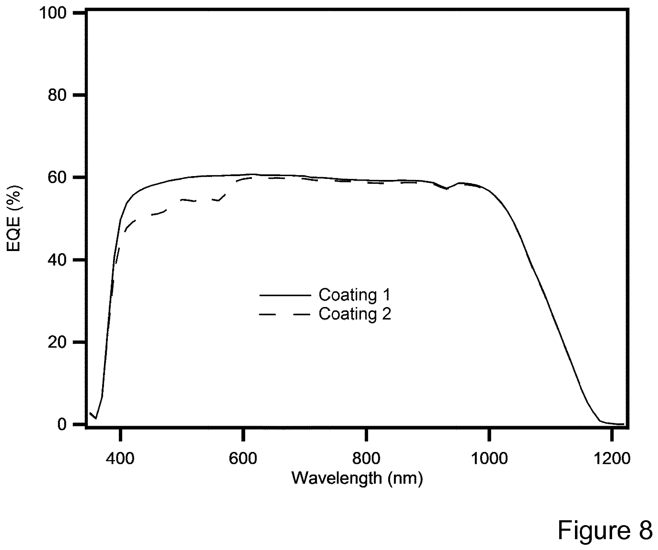

Figure 8 illustrates the results of a spectral analysis of two different PV modules 1 according to the invention, in which the fibre mesh 21 is made of polymer fibres of the same diameter and density, but coated with different coatings. Coating 1 is substantially of aluminium colour (grey, white), and coating 2 is brown, reflecting light in the 400-600nm wavelength range which hence does not enter into the photovoltaically-active layers of the PV device 15 contained within the PV module 1.

It should be noted, however, that the coloured coating 2 does not affect the EQE in the infrared range, since it is substantially transparent to these wavelengths. As a result, the efficiency of PV devices sensitive to infrared wavelengths is unaffected by this coating.

Further chemical / UV stability testes have been carried out on PV cells 1 with the configuration of figure 1, in order to identify particularly advantageous combinations of encapsulants and inks for printing onto the mesh 21 which are long-term stable.

Various samples were produced with various encapsulants, both ETFE (Norton ETFE, Saint-Gobain, 0.1 mm) and glass front-sheets 11, and various primary-coloured inks printed by ink-jet printing onto colourless glass fibre mesh 21 with 40 g/m² density and 0.3mm mesh thickness.

The samples were then exposed in a standard Q-sun Xe-3 UV test chamber, with exposure up to 4400h sunlight-equivalent at 60-70°. The results are presented in the following table, in which "stable" indicates that no colour change in either the ink or the encapsulant was observed at 4400h exposure, and "unstable" indicates that either ink or encapsulant discoloured yellow or brown in the vicinity of the fibres. The following table presents the results of these experiments, cyan, magenta and yellow inks being tested for each ink:

| **Ink / coloured fibres** | **Front sheet** | **Encapsulant type** | **Manufacturer** | **Stability?** |
|---|---|---|---|---|
| Kao - Collins (UV curable) cyan, magenta, yellow | ETFE | Thermal polyolefin - CVF | Dai Nippon Printing | Unstable at 3100h |
| " | " | EVA - F806 | Hangzhou First | Stable |
| " | " | PO First Enlight XUS66250 | Hangzhou First | Stable |
| " | Glass | Thermal Polyolefin - CVF | Dai Nippon Printing | Unstable at 2100h |
| " | " | EVA-F806 | Hangzhou First | Unstable at 3100h |
| " | " | PO First Enlight XUS66250 | Hangzhou First | Unstable at 1000h |
| Marabu (water-based) cyan, magenta, yellow | ETFE | Thermal polyolefin - CVF | Dai Nippon Printing | Unstable at 2100h |
| " | " | EVA-F806 | Hangzhou First | Unstable at 4400h |
| " | " | PO First Enlight XUS66250 | Hangzhou First | Unstable at 4400h |
| " | Glass | Thermal polyolefin - CVF | Dai Nippon Printing | Unstable at 4400h |
| " | " | EVA-F806 | Hangzhou First | Unstable at 3100h |
| " | " | PO First | Hangzhou | Unstable at 1000h |
| | | Enlight XUS66250 | First | |
| Sensient yellow, magenta, cyan HPL800 | ETFE | TPO - Photocap 35521 P | STR | Unstable at 1000h |
| " | " | PO First Enlight XUS66250 | Hangzhou First | Stable |
| " | Glass | Thermal polyolefin - CVF | Dai Nippon Printing | Unstable at 2100 h |
| " | " | EVA - F406 | Hangzhou First | Unstable at 1000h |
| " | " | EVA-F806 | Hangzhou First | Unstable at 1000h |
| " | " | TPO - Photocap 35521P | STR | Unstable at 1000h |
| " | " | PO First Enlight XUS66250 | Hangzhou First | Unstable at 1000h |
| Tiger Tigital^{®} Outdoor cyan, magenta, yellow | ETFE | Thermal polyolefin - CVF | Dai Nippon Printing | Stable |
| " | " | EVA-F806 | Hangzhou First | Stable |
| " | " | PO First Enlight XUS66250 | Hangzhou First | Stable |
| " | Glass | Thermal polyolefin - CVF | Dai Nippon Printing | Unstable at 2100h |
| " | " | EVA-F806 | Hangzhou First | Unstable at 2100h |
| " | " | PO First Enlight XUS66250 | Hangzhou First | Unstable at 1000h |
| Tiger Tigital^{®} | ETFE | Thermal | Dai Nippon | Stable |
| Universal | | polyolefin - CVF | Printing | |
| " | " | EVA-F806 | Hangzhou First | Stable |
| " | " | PO First Enlight XUS66250 | Hangzhou First | Stable |
| " | Glass | Thermal polyolefin - CVF | Dai Nippon Printing | Unstable at 2100h |
| " | " | EVA-F806 | Hangzhou First | Unstable at 2100h |
| " | " | PO First Enlight XUS66250 | Hangzhou First | Unstable at 1000h |

As can be seen from the foregoing, not every possible combination of front sheet material, encapsulant material and ink is stable. Indeed, no sample with a glass front sheet was stable, likely due to the lower oxygen permeability of glass in comparison to ETFE. Also, TPO was the encapsulant with the greatest likelihood of being stable, although not all TPO samples were stable. Also, several EVA samples were indeed stable.

Further examples of modules constructed according to figure 1 comprising coloured fibres are reported in the following. In each case the same glass fibre mesh as mentioned above was used as the fibre mesh 21, with 0.3mm mesh thickness at approximately 40 g/m² density, the mesh being woven. The front sheet 11 and back sheet 19 were of glass, and each front encapsulant layer 13a, 13b was 600µm thick transparent EVA. The rear encapsulant 17 was black-coloured polyolefin (Yparex 0F0027), 250µm thick. The fibre mesh 21 was bar coated with a dispersion of pigment particles in water. As a result, the fibres were printed with pigments, leading to coloured fibres.

A grey colour was produced by dispersing 2 wt% of TiO2 pigments (Kronox 1071, IMCD, Switzerland), and the white/grey balance can be adjusted by varying the concentration of TiO₂ pigment in the dispersion.

An imitation terra cotta colour was produced by dispersing 0.4 wt% of TiO₂ (as above), 0.3 wt% of red pigment (Bayferrox rot 110M, (Fe₂O₃), Harald Scholz & Co, Germany), and 0.15 wt% of yellow pigment (Vanadur Yellow 2108 (BiVO₄), Heubach, Germany) together in water.

The resulting modules exhibited excellent coloration and texture appearance, particularly suited for mounting on buildings.

Of course, the skilled person can create much more varied colours than those mentioned above, by means of mixing various pigments known to be compatible with encapsulant materials, or determined to be so by means of routine experimentation.

For generating colour contrast, many further additional possibilities are available. For instance, a black-coloured back encapsulant 17 or backsheet 19 can be used, which will not impact the module efficiency. A white lower front encapsulant layer 13a between the mesh 21 and the PV conversion device 15 can also be used. After the mesh 21 has been printed with inks or pigments, it can further be coated with a polymeric top-coat such as a fluoropolymer top-coat, for instance in order to better stabilise pigment particles, prior to being laminated. Such a fluoropolymer top coat can also be mixed directly with the pigment dispersion before applying it to the mesh.

It should be noted that various known pigments can be used, including but not limited to Fe2O3 or FeO(OH) for red colours, TiO2 or ZnO for white, Prussian Blue or a complex sulphur-containing sodium silicate for blue, and so on.

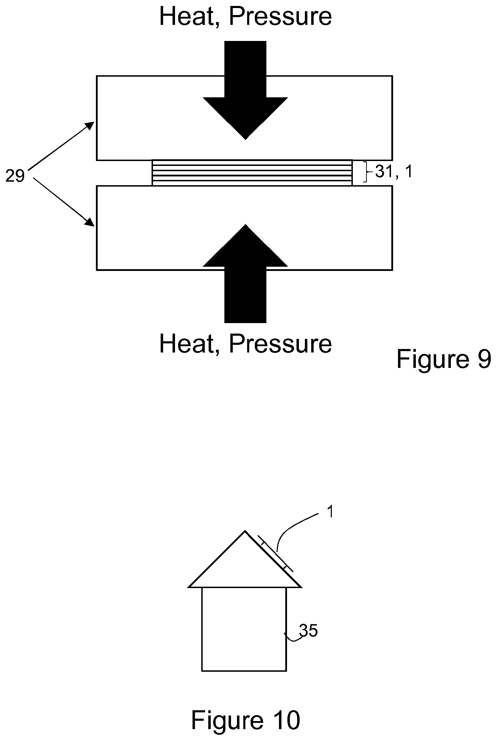

Figure 9 illustrates generically and schematically a method of manufacture of a PV module 1 according to the invention. A lamination device 29 is provided, in which is placed a layer stack 31 comprising the various layers as discussed above, disposed in the desired order. The layer stack may, depending on the embodiment as discussed above, comprise individual layers, or may comprise a pre-fabricated PV module to which the front encapsulant, mesh and front sheet will be applied to convert it into a PV module 1 according to the invention. The lamination device applies heat and pressure to the layer stack 31 sufficient to fuse the various encapsulant layers and thereby to assemble the layer stack 31 into the PV device 1 of the invention.

Finally, figure 10 illustrates a photovoltaic module 1 according to the invention mounted on the roof of a building 35. Alternatively, the PV module 1 can be mounted to an exterior wall, or integrated into the structure of the wall and/or roof, e.g. as cladding. In general terms, the PV module 1 can be mounted on or in the structure of the building 35.

Although the invention has been described in terms of specific embodiments, variations thereto are possible without departing from the scope of the invention as defined in the appended claims.

## Claims

1. Photovoltaic module (1) comprising:
- a front sheet (11) arranged on a light incident side of said photovoltaic module (1);
- a back sheet (19) arranged on an opposite side of said photovoltaic module (1) to said front sheet (11);
- a photovoltaic conversion device (15) disposed between said front sheet (11) and said back sheet (19);
- a front encapsulation layer (13) disposed between said photovoltaic conversion device (15) and said front sheet (11);
wherein said front encapsulation layer (13) comprises a fibre mesh (21) embedded therein,
**characterised in that** said fibre mesh (21) comprises coloured fibres and/or a colour, image or pattern printed thereupon, and **in that** at least a portion (13a) of said front encapsulation layer (13) is situated between said fibre mesh (21) and said photovoltaic conversion device (15) and is white or coloured.

2. Photovoltaic module (1) according to claim 1, wherein said fibre mesh (21) is embedded in said front encapsulation layer (13) such that said fibre mesh is out of contact with any layer adjacent to said front encapsulation layer (13).

3. Photovoltaic module (1) according to the preceding claim, wherein said fibre mesh (21) comprises individual fibres with a diameter between 5 µm and 1 mm, preferably between 5 µm and 20 µm, said individual fibres being arranged in a regular or irregular pattern, and being woven or unwoven.

4. Photovoltaic module (1) according to any preceding claim, wherein said fibre mesh (21) has a density of between 5 g/m² and 100 g/m², preferably between 5 g/m² and 80 g/m², further preferably between 10 g/m² and 75 g/m², further preferably between 35 g/m² and 50 g/m².

5. Photovoltaic module (1) according to any preceding claim, further comprising an internal front sheet (25) situated adjacent to said front encapsulation layer (13), and an internal front encapsulation layer (23) situated between said internal front sheet (25) and said photovoltaic conversion device (15).

6. Photovoltaic module (1) according to claim 1, wherein said encapsulant material is based on TPO and said front sheet (11) is based on ETFE.

7. Method of manufacturing a photovoltaic module (1) comprising the steps of:
- providing a lamination device (29);
- disposing in said lamination device (29) a layer stack (31) comprising:
- a front sheet (11) intended to be arranged on a light incident side of said photovoltaic module (1);
- a back sheet (19) intended to be arranged on an opposite side of said photovoltaic module (1) to said front sheet (11);
- a photovoltaic conversion device (15) disposed between said front sheet (11) and said back sheet (19);
- at least one front encapsulation layer (13, 13a) disposed between said photovoltaic conversion device (15) and said front sheet (11);
- a fibre mesh (21) immediately adjacent to said at least one front encapsulation layer (13, 13a), said fibre mesh (21) comprising coloured fibres and/or a colour, image or pattern printed thereupon;
- applying heat and pressure to said layer stack (31) so as to assemble it into said photovoltaic module (1),
wherein said at least one front encapsulation layer (13, 13a) is situated between said fibre mesh (21) and said photovoltaic conversion device and is white or coloured.

8. Method according to claim 7, comprising the step of:
- additionally disposing in said lamination device a further layer of front encapsulation material (13b) situated upon said fibre mesh (21) such that said fibre mesh is situated between two layers of encapsulation material (13a, 13b).

9. Method according to one of claims 7-8, wherein said fibre mesh (21) comprises individual fibres with a diameter between 10 µm and 1 mm, said individual fibres being arranged in a regular or irregular pattern, and being woven or unwoven.

10. Method according to one of claims 7-9, wherein said fibre mesh (21) has a density of between 5 g/m² and 250 g/m², preferably between 10 g/m² and 150 g/m², further preferably between 35 g/m² and 50 g/m².

11. Building (35) comprising at least one photovoltaic module (1) according to one of claims 1-6.

## Patentansprüche

1. Photovoltaikmodul (1), umfassend:
- eine Frontfolie (11), die auf einer Lichteinfallseite des Photovoltaikmoduls (1) angeordnet ist;
- eine Rückfolie (19), die auf einer der Frontfolie (11) gegenüberliegenden Seite des Photovoltaikmoduls (1) angeordnet ist;
- eine Photovoltaik-Umwandlungsvorrichtung (15), die zwischen der Frontfolie (11) und der Rückfolie (19) angeordnet ist;
- eine vordere Verkapselungsschicht (13), die zwischen der Photovoltaik-Umwandlungsvorrichtung (15) und der Frontfolie (11) angeordnet ist;
wobei die vordere Verkapselungsschicht (13) ein darin eingebettetes Fasernetz (21) umfasst,
**dadurch gekennzeichnet, dass** das Fasernetz (21) farbige Fasern und/oder eine Farbe, ein Bild oder ein Muster umfasst, die darauf gedruckt sind, und dass sich mindestens ein Teil (13a) der vorderen Verkapselungsschicht (13) zwischen dem Fasernetz (21) und der Photovoltaik-Umwandlungsvorrichtung (15) befindet und weiß oder farbig ist.

2. Photovoltaikmodul (1) nach Anspruch 1, wobei das Fasernetz (21) in die vordere Verkapselungsschicht (13) eingebettet ist, so dass das Fasernetz nicht mit einer an die vordere Verkapselungsschicht (13) angrenzenden Schicht in Kontakt steht.

3. Photovoltaikmodul (1) nach dem vorhergehenden Anspruch, wobei das Fasernetz (21) einzelne Fasern mit einem Durchmesser zwischen 5 µm und 1 mm, vorzugsweise zwischen 5 µm und 20 µm, umfasst, wobei die einzelnen Fasern in einem regelmäßigen oder unregelmäßigen Muster angeordnet und gewebt oder ungewebt sind.

4. Photovoltaikmodul (1) nach einem der vorstehenden Ansprüche, wobei das Fasernetz (21) eine Dichte zwischen 5 g/m² und 100 g/m², vorzugsweise zwischen 5 g/m² und 80 g/m², weiter vorzugsweise zwischen 10 g/m² und 75 g/m², weiter vorzugsweise zwischen 35 g/m² und 50 g/m², aufweist.

5. Photovoltaikmodul (1) gemäß einem der vorstehenden Ansprüche, das ferner eine innere Frontfolie (25), die angrenzend an die vordere Verkapselungsschicht (13) angeordnet ist, und eine innere vordere Verkapselungsschicht (23), die zwischen der inneren Frontfolie (25) und der Photovoltaik-Umwandlungsvorrichtung (15) angeordnet ist, umfasst.

6. Photovoltaikmodul (1) nach Anspruch 1, wobei das Einkapselungsmaterial auf TPO basiert und die Frontfolie (11) auf ETFE basiert.

7. Verfahren zur Herstellung eines Photovoltaikmoduls (1), das die folgenden Schritte umfasst:
- Bereitstellen einer Laminiervorrichtung (29);
- Anordnen eines Schichtstapels (31) in der Laminiervorrichtung (29), der Folgendes umfasst:
- eine Frontfolie (11), die dazu bestimmt ist, auf einer Lichteinfallseite des Photovoltaikmoduls (1) angeordnet zu werden;
- eine Rückfolie (19), die dazu bestimmt ist, auf einer der Frontfolie (11) gegenüberliegenden Seite des Photovoltaikmoduls (1) angeordnet zu werden;
- eine Photovoltaik-Umwandlungsvorrichtung (15), die zwischen der Frontfolie (11) und der Rückfolie (19) angeordnet ist;
- mindestens eine vordere Verkapselungsschicht (13, 13a), die zwischen der Photovoltaik-Umwandlungsvorrichtung (15) und der Frontfolie (11) angeordnet ist;
- ein Fasernetz (21), das unmittelbar an die mindestens eine vordere Verkapselungsschicht (13, 13a) angrenzt, wobei das Fasernetz (21) farbige Fasern und/oder eine Farbe, ein Bild oder ein Muster umfasst, die darauf gedruckt sind;
- Aufbringen von Wärme und Druck auf den Schichtstapel (31), um ihn zu dem Photovoltaikmodul (1) zusammenzufügen,
wobei die vordere Verkapselungsschichten (13, 13a) zwischen dem Fasernetz (21) und der Photovoltaik-Umwandlungsvorrichtung angeordnet ist und weiß oder farbig ist.

8. Verfahren nach Anspruch 7, das das folgende Schritt umfasst:
- zusätzlich in der Laminiervorrichtung eine weitere Schicht aus vorderem Verkapselungsmaterial (13b) anzuordnen, die auf dem Fasernetz (21) liegt, so dass das Fasernetz zwischen zwei Schichten aus Verkapselungsmaterial (13a, 13b) liegt.

9. Verfahren nach einem der Ansprüche 7-8, wobei das Fasernetz (21) einzelne Fasern mit einem Durchmesser zwischen 10 µm und 1 mm umfasst, wobei die einzelnen Fasern in einem regelmäßigen oder unregelmäßigen Muster angeordnet und gewebt oder ungewebt sind.

10. Verfahren nach einem der Ansprüche 7-9, wobei das Fasernetz (21) eine Dichte zwischen 5 g/m² und 250 g/m², vorzugsweise zwischen 10 g/m² und 150 g/m², weiter vorzugsweise zwischen 35 g/m² und 50 g/m², aufweist.

11. Gebäude (35) mit mindestens einem Photovoltaikmodul (1) gemäß einem der Ansprüche 1-6.

## Revendications

1. Module photovoltaïque (1) comprenant :
- une plaque avant (11) disposée sur un côté d'incidence de la lumière dudit module photovoltaïque (1) ;
- une plaque arrière (19) disposée sur un côté dudit module photovoltaïque (1) opposé à ladite plaque avant (11) ;
- un dispositif de conversion photovoltaïque (15) disposé entre ladite plaque avant (11) et ladite plaque arrière (19) ;
- une couche d'encapsulation avant (13) disposée entre ledit dispositif de conversion photovoltaïque (15) et ladite plaque avant (11) ;
dans lequel ladite couche d'encapsulation avant (13) comprend un maillage de fibres (21) qui y est intégré,
**caractérisé en ce que** le maillage de fibres (21) comprend des fibres colorées et/ou une couleur, une image ou un motif imprimé dessus, et **en ce qu'**au moins une partie (13a) de ladite couche d'encapsulation avant (13) est située entre ledit maillage de fibres (21) et ledit dispositif de conversion photovoltaïque (15) et est blanche ou colorée.

2. Module photovoltaïque (1) selon la revendication 1, dans lequel ledit maillage de fibres (21) est intégré dans ladite couche d'encapsulation avant (13) de telle sorte que ledit maillage de fibres est hors de contact avec l'une quelconque des couches adjacentes à ladite couche d'encapsulation avant (13).

3. Module photovoltaïque (1) selon la revendication précédente, dans lequel ledit maillage de fibres (21) comprend des fibres individuelles ayant un diamètre compris entre 5 µm et 1 mm, de préférence entre 5 µm et 20 µm, lesdites fibres individuelles étant disposées selon un motif régulier ou irrégulier et étant tissées ou non tissées.

4. Module photovoltaïque (1) selon l'une des revendications précédentes, dans lequel ledit maillage de fibres (21) a une densité comprise entre 5 g/m² et 100 g/m², de préférence entre 5 g/m² et 80 g/m², plus préférablement entre 10 g/m² et 75 g/m², encore plus préférablement entre 35 g/m² et 50 g/m².

5. Module photovoltaïque (1) selon l'une quelconque des revendications précédentes, comprenant en outre une plaque avant interne (25) disposée de manière adjacente à ladite couche d'encapsulation avant (13), et une couche d'encapsulation avant interne (23) disposée entre ladite plaque avant interne (25) et ledit dispositif de conversion photovoltaïque (15).

6. Module photovoltaïque (1) selon la revendication 1, dans lequel ledit encapsulant est à base de TPO et ladite plaque avant (11) est à base d'ETFE.

7. Procédé de fabrication d'un module photovoltaïque (1), comprenant les étapes consistant à :
- fournir un dispositif de laminage (29) ;
- disposer un empilement de couches (31) dans le dispositif de laminage (29), qui comprend :
- une plaque avant (11) destinée à être disposée sur un côté d'incidence de la lumière dudit module photovoltaïque (1) ;
- une plaque arrière (19) destinée à être placée sur un côté dudit module photovoltaïque (1) opposé à ladite plaque avant (11) ;
- un dispositif de conversion photovoltaïque (15) disposé entre ladite plaque avant (11) et ladite plaque arrière (19) ;
- au moins une couche d'encapsulation avant (13, 13a) disposée entre ledit dispositif de conversion photovoltaïque (15) et ladite plaque avant (11) ;
- un maillage de fibres (21) immédiatement adjacent à ladite au moins une couche d'encapsulation avant (13, 13a), ledit maillage de fibres (21) comprenant des fibres colorées et/ou une couleur, une image ou un motif imprimé dessus ;
- appliquer de la chaleur et de la pression audit empilement de couches (31) pour l'assembler en formant ledit module photovoltaïque (1),
dans lequel ladite au moins une couche d'encapsulation avant (13, 13a) est disposée entre ledit maillage de fibres (21) et ledit dispositif de conversion photovoltaïque et est blanche ou colorée.

8. Procédé selon la revendication 7, comprenant l'étape consistant à :
- placer en outre dans ledit dispositif de laminage une couche supplémentaire d'encapsulation avant (13b) recouvrant ledit maillage de fibres (21) de telle sorte que ledit maillage de fibres soit pris en sandwich entre deux couches d'encapsulation (13a, 13b).

9. Procédé selon l'une quelconque des revendications 7-8, dans lequel ledit maillage de fibres (21) comprend des fibres individuelles ayant un diamètre compris entre 10 µm et 1 mm, lesdites fibres individuelles étant disposées selon un motif régulier ou irrégulier et étant tissées ou non tissées.

10. Procédé selon l'une quelconque des revendications 7 à 9, dans lequel ledit maillage de fibres (21) a une densité comprise entre 5 g/m² et 250 g/m², de préférence entre 10 g/m² et 150 g/m², plus préférablement entre 35 g/m² et 50 g/m².

11. Bâtiment (35) comprenant au moins un module photovoltaïque (1) selon l'une des revendications 1 à 6.
